# EUROPÄISCHE PATENTSCHRIFT

(11) **EP 2 267 812 B1**
(45) Veröffentlichungstag und Bekanntmachung des Hinweises auf die Patenterteilung: **04.01.2012**
(21) Anmeldenummer: 10179438.6
(22) Anmeldetag: 29.08.2006
(51) Int. Cl.: H01L 51/00

(54) **Neue Materialien zur n-Dotierung der Elektronentransportschichten in organischen elektronischen Bauelementen, Verwendung dazu sowie organische elektronische Bauelemente**
Novel materials for n-type doping of the electron transporting layers in organic electronic devices, their use and organic electronic devices
Matières de dopage de type n des couches de transport d'électrons dans des composants électroniques organiques, leur utilisation et dispositifs électroniques organiques

(30) Priorität: 05.09.2005 DE 102005042104
(43) Veröffentlichungstag der Anmeldung: 29.12.2010
(62) Teilanmeldung aus: 06793040.4
(73) Patentinhaber: OSRAM Opto Semiconductors GmbH, 93055 Regensburg (DE)
(72) Erfinder: Kanitz, Andreas, 91315, Höchstadt (DE)
(74) Vertreter: Epping - Hermann - Fischer

(56) Entgegenhaltungen:
- EP-A- 1 394 236
- WO-A2-01/91203
- JP-A- 2000 103 975
- WERNER A ET AL: "N-TYPE DOPING OF ORGANIC THIN FILMS USING CATIONIC DYES" ADVANCED FUNCTIONAL MATERIALS, WILEY VCH, WIENHEIM, DE, Bd. 14, Nr. 3, März 2004 (2004-03), Seiten 255-260, XP001047750 ISSN: 1616-301X
- JOHNSON ET AL: "Electroluminescence from single layer molecularly doped polymer films" PURE & APPLIED CHEMISTRY, PERGAMON PRESS, OXFORD, GB, Bd. 67, Nr. 1, 1995, Seiten 175-182, XP002097445 ISSN: 0033-4545

## Beschreibung

Die Erfindung betrifft neue Materialien zur Verbesserung der Elektroneninjektion und des Elektronentransportes in organischen Bauelementen wie organischen Leuchtdioden (OLEDs), organischen Feldeffekttransistoren (OFETs) und organischen Solarzellen.

In den letzten Jahren sind insbesondere für organische Leuchtdioden Materialien bekannt geworden, durch die die Elektroneninjektion sowie der Elektronentransport in OLEDs verbessert wird(Pat.: Novaled GmbH Dresden DE_10307125_A1 01.08.2004) Dies bewirkt zusätzlich eine Absenkung der Betriebsspannung bei gleicher Effizienz der OLED. A Werner et al. beschreibt in Adv. Funct. Mat. 2004, 14(3), 255-260 die Verwendung eines Kationischen Farbstoffes als n-Dotand.

Diese Materialien liegen als Precursor vor und werden durch den Aufdampfprozess in starke Elektronendonoren umgewandelt, so dass sie coverdampft mit dem Elektronentransporter in geringer Menge die Elektronentransportschicht bzw. die Emitter-schicht der OLED dotieren (n-Doping genannt). Dies führt zu einer elektronischen Wechselwirkung mit dem Elektronentransportmaterial bzw. dem Emitter, wodurch solche Zusätze die Reduktion des Elektronentransportmaterials bzw. des Emittermaterials (also die Elektronenaufnahme in das LUMO [tiefstes unbesetztes Molekülorbital] des Elektonentransport- bzw. Emittermaterials) erleichtern, was sonst ausschließlich durch die Energie des elektrischen Feldes bewirkt wird. Infolgedessen wird bei schwächerem, elektrischem Feld (das einer geringeren Betriebsspannung entspricht) die gleiche Effizienz erreicht, die ohne diese Materialien nur unter stärkerem elektrischem Feld möglich war.

Bei den bisherigen bekannten Materialien ist jedoch vor allem die Stabilität und der injektions- und elektronentranportfördernde Effekt noch nicht zufrieden stellend.

Aufgabe der vorliegenden Erfindung ist es deshalb, ein Material zur Verbesserung der Elektroneninjektion und/oder des Elektronentransportes in organischen Bauelementen zu schaffen, das die Nachteile des Standes der Technik, insbesondere die fehlende Stabilität des injektions- und elektronentransportfördernden- Effekts zu erhöhen.

Die Lösung der Aufgabe und Gegenstand der Erfindung werden in den Ansprüchen, den Beispielen und der Beschreibung offenbart.

Erfindungsgemäß kann der injektions- und elektronentranportfördernde Effekt durch die neuen zu beanspruchenden Materialien der Substrukturen **1 - 3** noch wesentlich verstärkt werden und ihre Stabilität durch die geänderten Bindungsverhältnisse ebenfalls verbessert werden.

Ursachen dafür bilden die Verbrückung der Dialkylaminosubstituenten mit dem aromatischen Kern in Substruktur **1** sowie die neu angewendeten redox-stabilen Triarylamindonoren der Substrukturen **2** und **3**, die einerseits durch Umwandlung über einen Carbenmechanismus in einem Hochvakuumprozess zu dimeren Tetradonorethylenen (**1a** und **2a**) bzw. Tetradonorfulvalenen (**3a**) abreagieren, die in einer Elektronenakzeptormatrix sofort in der Lage sind ein Elektron zu übertragen oder andererseits aus dem Carbenzustand direkt mit der Akzeptormatrix einen elektonen-übertragenden komplexartigen Übergangszustand bilden, der wohl in seiner physikalischen Wirkung, nicht aber in seiner chemischen Struktur charakterisiert werden kann.

Eine weitere Möglichkeit besteht darin die Tetradonorethylene (**1a** und **2a**) bzw. die Tetradonorfulvalene (**3a**) direkt zu synthetisieren und die Elektronenakzeptormatrix damit zu dotieren.

Die Materialien der Substrukturen **2** und **3** besitzen darüber hinaus wegen der Triarylaminsubstituenten gute Glasbildungseigenschaften, die ebenfalls zur Verbesserung des Ladungstransportes und der Ladungsübertragung und damit zur Leitfähigkeitserhöhung der Elektronentransport-/Emitter-Schicht beitragen.

Substrukturen der Prekursor (Carbenoide): 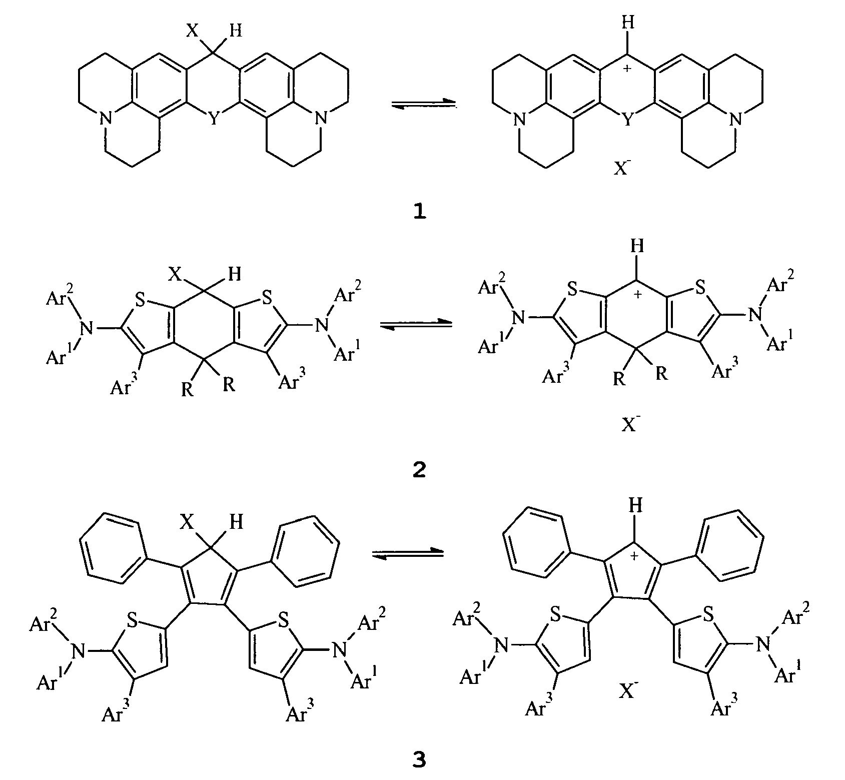 in denen die Substituenten folgende Bedeutungen besitzen:
**X** hat die Bedeutung eines Anions bevorzugt von Chlorid und Formiat,
**Y** steht für O, S oder N-Ar, wobei Ar bevorzugt Phenyl oder 1-Naphthyl darstellt,
**R** bedeutet Alkyl, bevorzugt Methyl,
**Ar¹** bis **Ar³** stehen für Arylreste, deren Bedeutung unabhängig voneinander bevorzugt Phenyl, 1-Naphthyl und 2-Naphthyl ist.

### Substrukturen der Carbendimere:

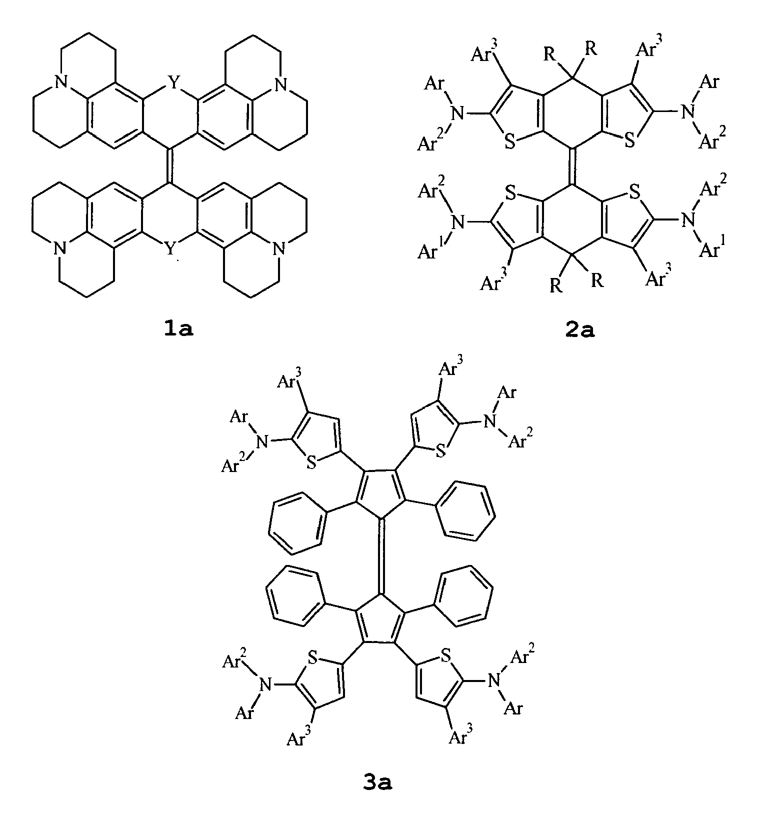

Die neuen Materialien, die geeignet sind den Elektronentransport und die Elektroneninjektion durch chemische Wechselwirkung mit beliebigen Elektronentransport- und/oder Emitterschichten zu verbessern können somit universell in polymerelektronischen Bauelementen erfolgreich eingesetzt werden, darunter werden vorrangig alle Technologien zur Herstellung von organischen Leuchtdioden (OLEDs), organischen Feldeffekttransistoren (OFETs) und Bauelementen auf Basis organischer photovoltaischer Bauelemente wie organische Solarzellen verstanden.

### Ausführungsbeispiele:

### 1) Darstellung eines Carbenoids 1

Synthese durch Vilsmeyerformylierung von 8-Hydroxyjulolidin und Kondensation zum Methinfarbstoff **1** im Überschuss von 8-Hydroxyjulolidin und Zusatz von Kaliumchlorid.

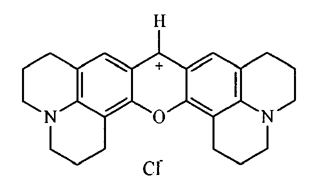

### 2) Darstellung eines Dimeren 1a

a) Synthese des Michlers-Keton-Typ aus 8-Hydroxyjulolidin und Diethylcarbonat.
b) Dimerisierung des Michlers-Keton Typ durch Mc Murry Reaktion

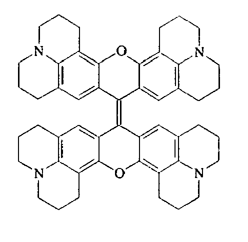

### 3) Darstellung eines Carbenoids 2

a) Synthese von 2-Phenylessigsäurediphenylamid aus Diphenylamin und Phenylessigsäurechlorid
b) Synthese von 2-Phenylthioessigsäurediphenylamid aus 2-Phenylessigsäurediphenylamid und Lawessons Reagenz.
c) Synthese von Di-[2-(diphenylamino)-3-phenyl-thien-4-yl]-dimethyl-methan aus 2-Phenylthioessigsäurediphenylamid und 1,5-Dibrom-3,3-dimethyl-pentan-2,4-dion.
d) Vilsmeyerformylierung des Di-[2-(diphenylamino)-3-phenyl-thien-4-yl]-dimethyl-methan unter Bildung des Methinfarbstoffes **2** und Anionenaustausch mittels Kaliumchlorid.

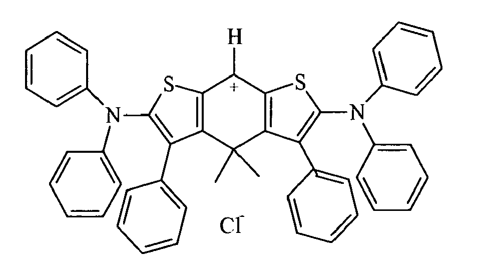

### 4) Darstellung eines Dimeren 2a

a) Synthese des Michlers-Keton-Typ durch Reaktion von Di-[2-(diphenylamino)-3-phenyl-thien-4-yl]-dimethyl-methan **3c** mit Diethylcarbonat.
b) Dimerisierung des Michlers-Keton Typ **4a** durch Mc Murry Reaktion.

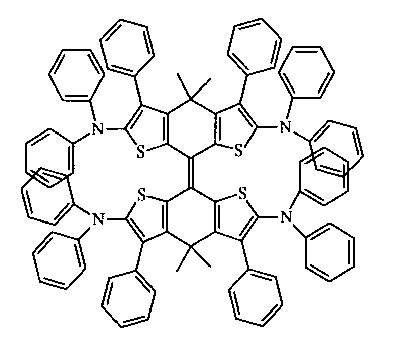

### 5) Darstellung eines Carbenoids 3

a) Synthese von 2-Phenylessigsäurephenyl-1-naphthylamid aus Phenyl-1-naphthylamin und Phenylessigsäurechlorid
b) Synthese von 2-Phenylthioessigsäurephenyl-1-naphthylamid aus 2-Phenylessigsäurephenyl-1-naphthylamid und Lawessons Reagenz.
c) Synthese von 2-Phenyl-3-mopholino-thioacrylsäurephenyl-1-naphthylamid aus 2-Phenylthioessigsäurephenyl-1-naphthylamid, Morpholin und Orthoameisensäureester.
d) Synthese von 1,2-Di-[2-(phenyl-1-naphthylamino)'-3-phenyl-thien-5-yl]-ethan-1,2-dion aus 2-Phenyl-3-mopholinothioacryl-säurephenyl-1-naphthylamid und 1,4-Dibrombutan-2,3-dion.
e) Kondensation von 2,5-Diphenyl-3,4-di-[2-(phenyl-1-naphthyl-amino)-3-phenyl-thien-5-yl]-cyclopentadienon aus 1,2-Di-[2-(phenyl-1-naphthylamino)-3-phenyl-thien-5-yl]-ethan-1,2-dion und 1,3-Diphenylaceton mit Kalium-tert.-butylat.
f) Reduktion des 2,5-Diphenyl-3,4-di-[2-(phenyl-1-naphthyl-amino)-3-phenyl-thien-5-yl]-cyclopentadienon zum Carbinol mittels Natriumborhydrid.
g) Bildung des Methinfarbstoffes **3** aus dem Carbinol **5f** mit HCl.

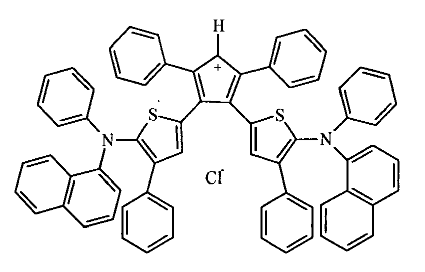

### 6) Darstellung eines Dimeren 3a

a) Dimerisierung des Michlers-Keton Typ **5e** durch Mc Murry Reaktion.

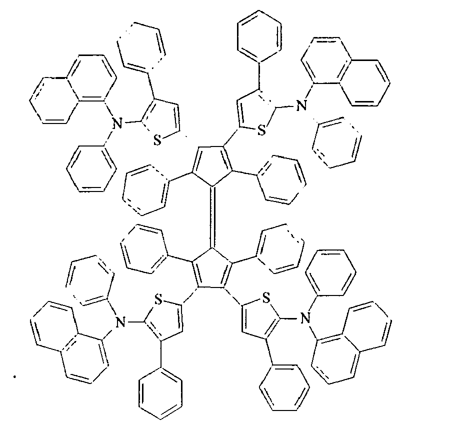

Die Erfindung betrifft neue Materialien auf Basis von Donorcarbenenintermediaten zur Verbesserung der Elektroneninjektion und des Elektronentransportes in organischen elektronischen Bauelementen wie organischen Leuchtdioden (OLEDs), organischen Feldeffekttransistoren (OFETs) und Bauelementen auf Basis organischer Photovoltaik wie insbesondere organischen Solarzellen.

## Patentansprüche

1. Material zur n-Dotierung der Elektronentransportschicht in organischen elektronischen Bauelementen zumindest eine Komponente gemäß einer der drei unten stehenden Strukturen **1a** bis 3a umfassend, 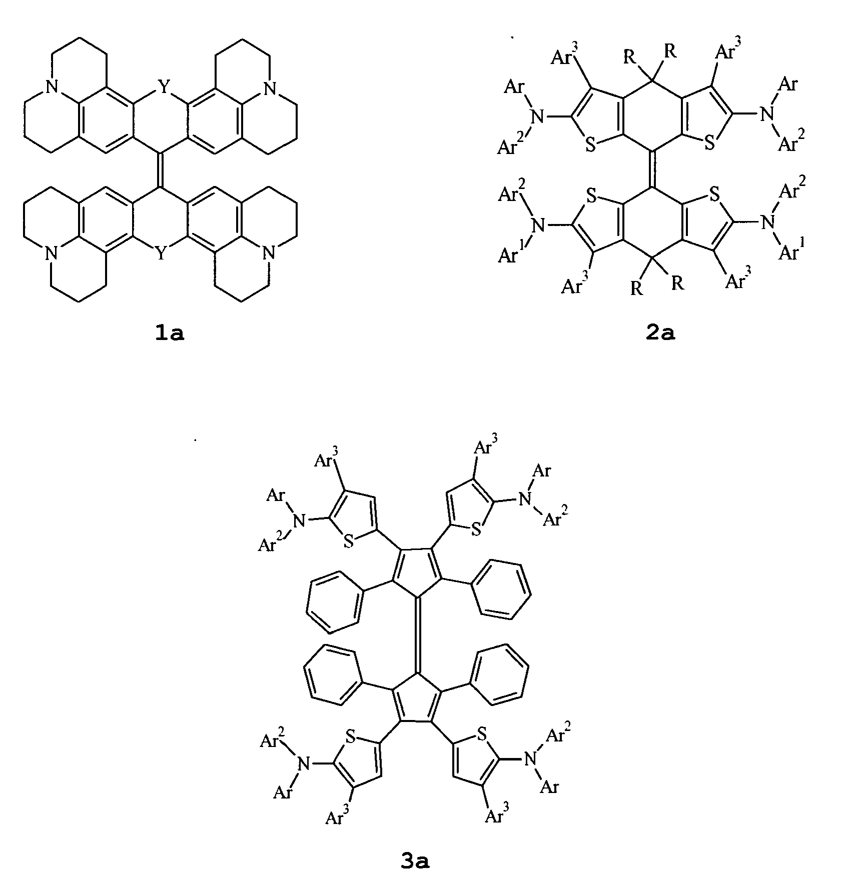 wobei die Substituenten folgende Bedeutungen besitzen:
**Y** steht für O, S oder N-Ar, wobei Ar bevorzugt Phenyl oder 1-Naphthyl darstellt,
**R** bedeutet Alkyl, bevorzugt Methyl,
**Ar¹** bis **Ar³** stehen für Arylreste, deren Bedeutung unabhängig voneinander ist.

2. Material nach Anspruch 1, wobei
**R** Methyl ist und/oder
**Ar¹** bis **Ar³** beliebig und unabhängig voneinander aus der Gruppe umfassend Phenyl, 1-Naphthyl und 2-Naphthyl ausgewählt ist.

3. Verfahren zur Herstellung eines Materials nach einem der Ansprüche 1 oder 2 durch Umwandlung der zur den Strukturen 1a bis 3a jeweils korrespondierenden, unten stehenden Strukturen 1 bis 3 in einem Hochvakuumprozess: 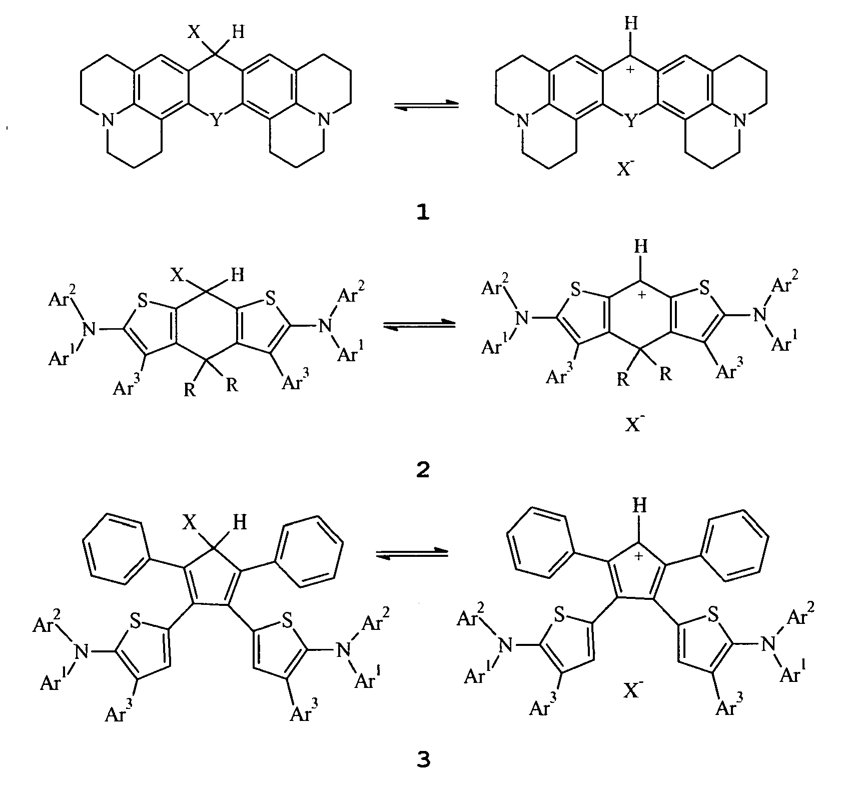 wobei die Substituenten folgende Bedeutungen besitzen:
**X**⁻ hat die Bedeutung eines Anions
**Y** steht für O, S oder N-Ar, wobei Ar bevorzugt Phenyl oder 1-Naphthyl darstellt,
**R** bedeutet Alkyl, bevorzugt Methyl,
**Ar¹** bis **Ar³** stehen für Arylreste, deren Bedeutung unabhängig voneinander ist.

4. Verwendung eines Materials nach einem der Ansprüche 1 oder 2 zur n-Dotierung einer Elektronentransportschicht eines organischen elektronischen Bauelements.

5. Organisches elektronisches Bauelement zumindest zwei Elektroden mit einer aktiven Schicht umfassend, wobei zwischen zumindest einer Elektrode und der aktiven Schicht eine Elektronentransportschicht angeordnet ist, die mit einem Material nach einem der Ansprüche 1 oder 2 dotiert ist.

6. Organisches elektronisches Bauelement nach Anspruch 5, wobei das organisch elektronische Bauelement eine organische Leuchtdiode ist.

## Claims

1. A material for n-doping of the electron transport layer in organic electronic components, comprising at least one component according to one of the three structures **1a** to **3a** below 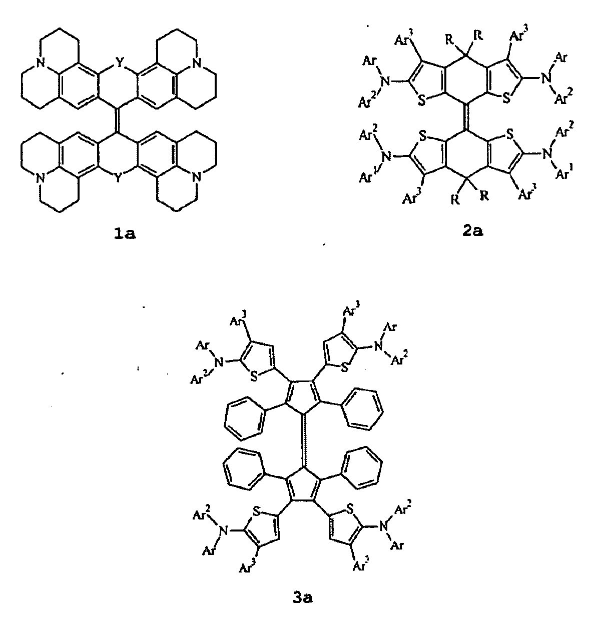 where the substituents are each defined as follows:
Y is O, S or N-Ar, wherein Ar is preferably phenyl or 1-naphthyl,
R is alkyl, preferably methyl,
Ar¹ to Ar³ are each aryl moieties, which are each defined independently of one another.

2. The material according to Claim 1, wherein
R is methyl and/or
Ar¹ to Ar³ are each arbitrarily and independently selected from the group comprising phenyl, 1-naphthyl and 2-naphthyl.

3. A process for producing a material according to either of Claims 1 and 2 by converting the structures 1 to 3 below, each corresponding to structures 1a to 3a, in a high-vacuum process: 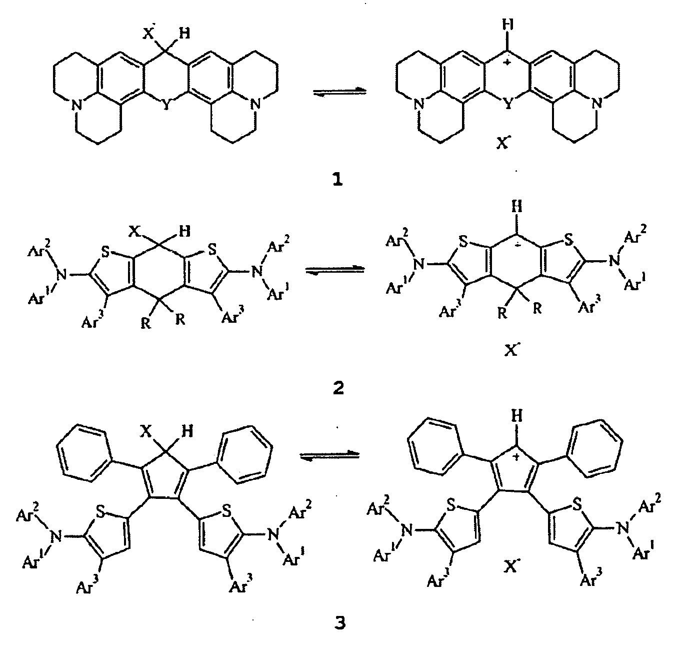 where the substituents are each defined as follows:
**x⁻** is defined as an anion,
**Y** is O, S or N-Ar, wherein Ar is preferably phenyl or 1-naphthyl,
**R** is alkyl, preferably methyl,
**Ar¹** to **Ar³** are each aryl moieties, which are each defined independently of one another.

4. A use of a material according to either of Claims 1 and 2 for n-doping of an electron transport layer of an organic electronic component.

5. An organic electronic component comprising at least two electrodes with an active layer, wherein an electron transport layer, which is doped with a material according to either of Claims 1 and 2, is arranged between at least one electrode and the active layer.

6. The organic electronic component according to Claim 5, wherein the organic electronic component is an organic light-emitting diode.

## Revendications

1. Matériau pour le dopage de type n de la couche de transport d'électrons dans des modules électroniques organiques, comprenant au moins un composant selon l'une des trois structures **1a** à **3a** ci-dessous, 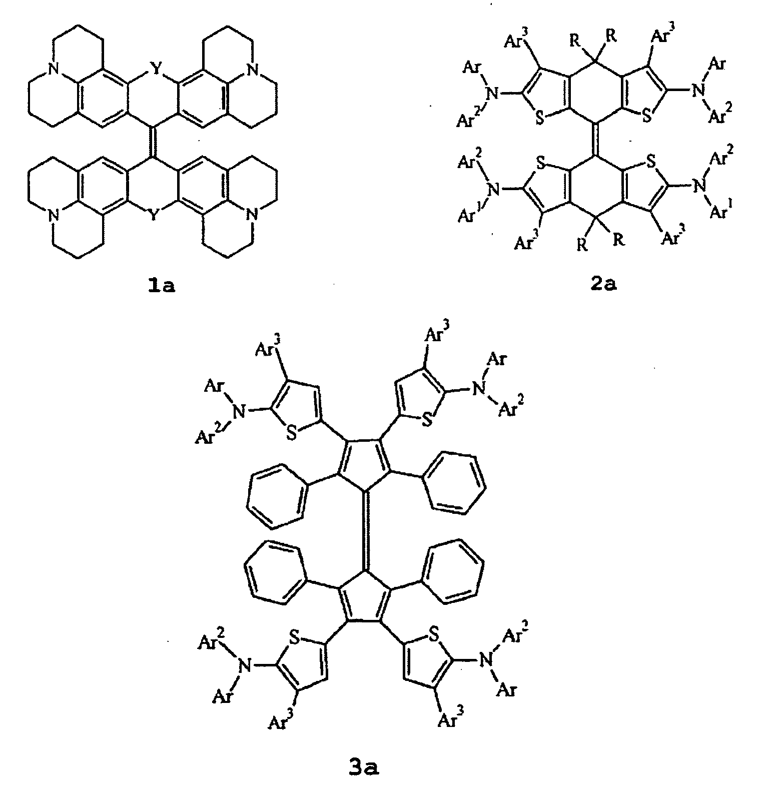 où les substituants présentent les significations suivantes :
**Y** représente O, S ou N-Ar, où Ar représente de préférence phényle ou 1-naphtyle,
**R** représente alkyle, de préférence méthyle,
**Ar¹** à **Ar³** représentent des groupes aryle, dont les significations sont indépendantes les unes des autres.

2. Matériau selon la revendication 1, où
**R** représente méthyle et/ou
**Ar¹** à **Ar³** sont choisis, de manière quelconque et indépendamment les uns des autres, dans le groupe comprenant phényle, 1-naphtyle et 2-naphtyle.

3. Procédé pour la préparation d'un matériau selon l'une quelconque des revendications 1 ou 2 par transformation des structures 1 à 3 ci-dessous, correspondant respectivement aux structures 1a à 3a dans un procédé sous un vide poussé : 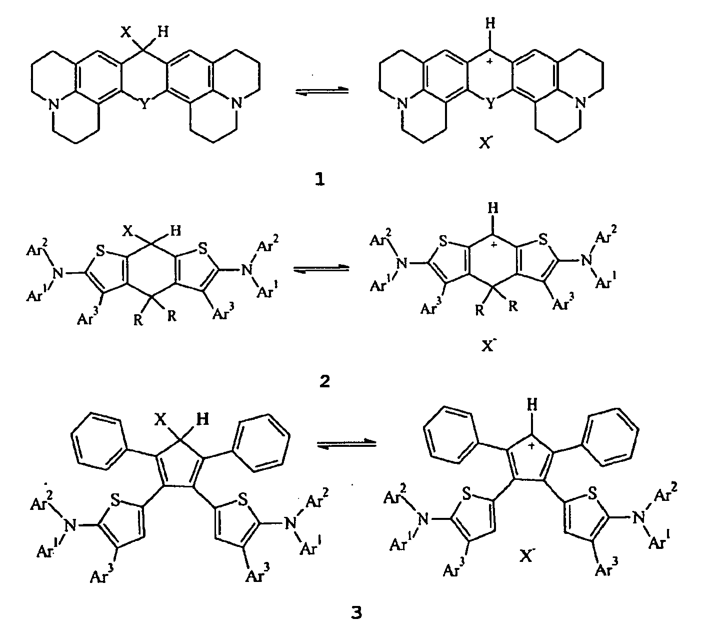 où les substituants présentent les significations suivantes :
X⁻ représente un anion
Y représente O, S ou N-Ar, où Ar représente de préférence phényle ou 1-naphtyle,
R représente alkyle, de préférence méthyle,
Ar¹ à Ar³ représentent des groupes aryle, dont les significations sont indépendantes les unes des autres.

4. Utilisation d'un matériau selon l'une quelconque des revendications 1 ou 2 pour le dopage de type n d'une couche de transport d'électrons d'un module électronique organique.

5. Module électronique organique comprenant au moins deux électrodes avec une couche active, où une couche de transport d'électrons, dopée d'un matériau selon l'une quelconque des revendications 1 ou 2, étant disposée entre au moins une électrode et la couche active.

6. Module électronique organique selon la revendication 5, le module électronique organique étant une diode électroluminescente organique.
